# EUROPÄISCHE PATENTANMELDUNG

(11) **EP 2 146 382 A1**
(43) Veröffentlichungstag der Anmeldung: **20.01.2010**
(21) Anmeldenummer: 08160613.9
(22) Anmeldetag: 17.07.2008
(51) Int. Cl.: H01L 31/048

(54) **Photovoltaikelement**

(71) Anmelder: Sika Technology AG, 6340 Baar (CH)
(72) Erfinder: Strehler, Hans-Jakob, CH-8910 Affoltern am Albis (CH); Hansen, Werner Hillebrand, D-82266 Inning (DE); Jurisch, Randall, La Crescenta, California 91214 (US); Schür, Klaus, D-55218 Ingelheim (DE)
(74) Vertreter: Sika Patent Attorneys

(57) **Zusammenfassung**

Die Erfindung betrifft ein Photovoltaikelement (1) aufweisend eine Dichtungsbahn (8) mit mindestens einem, auf einer Seite der Dichtungsbahn befestigten Photovoltaikmodul (2.1-2.4), welches Kontaktstellen (4.1, 4.2) und Mittel zum elektrischen Anschluss (6.1, 6.2) aufweist.

Die Erfindung zeichnet sich dadurch aus, dass die Kontaktstellen (4.1, 4.2) des Photovoltaikmoduls (2.1-2.4) auf der zur Dichtungsbahn (8) gewandten Seite angeordnet sind, und die Mittel zum elektrischen Anschluss (6.1, 6.2) die Dichtungsbahn (8) durchstossen.

## Beschreibung

### Technisches Gebiet

Die Erfindung geht aus von einem Photovoltaikelement nach dem Oberbegriff des ersten Anspruches.

### Stand der Technik

Ähnliche Photovoltaikelemente sind allgemein bekannt und werden meist zur Aufbringung auf ein Flachdach verwendet. Hierbei werden meist mehrere Photovoltaikelemente mit ihren Dichtungsbahnen nebeneinander verschweisst, so dass die Summe der verschweissten Photovoltaikelemente neben der Stromerzeugungsfunktion auch gleichzeitig die Funktion einer Dachabdichtung erfüllt.

Grundsätzlich unterscheidet man einlagige und zweilagige Photovoltaik-Systeme. Bei einem zweilagigen System übernimmt die obere Lage die Photovoltaikfunktion, während die untere Lage die Abdichtfunktion übernimmt. Die Lagen werden getrennt aufgebracht, wobei die untere Lage für die elektrischen Anschlüsse nicht durchstossen wird. Die Verkabelung erfolgt meist nach dem Abschluss der Abdichtungsarbeiten, so dass keine Beschädigungsgefahr der Kontaktstellen beim Begehen des Daches besteht oder ein aufwändiges Schützen der Kontaktstellen durch mechanische Abdeckungen entfällt. Die Abdichtsituation ist sehr sicher, allerdings ist diese Variante relativ kostenaufwändig, da zwei Kunststoffdichtungsbahnen verwendet und aufgebracht werden müssen.

Die einlagigen Systeme werden zusätzlich nach der Art der Verkabelung unterschieden:

Einerseits das einlagige System, bei dem der Anschluss der Photovoltaikmodule an die Verkabelung von unten erfolgt, wobei die Abdichtungsbahn durchstossen wird. Die Verkabelung selbst wird dabei in die Wärmedämmschicht des Daches eingelegt. Hierbei wird das gesamte Dachschichtenpaket, also Isolierung + Dampfsperre + Tragkonstruktion, pro vier Photovoltaikmodule einmal und die Abdichtungsebene alle 2 - 3 m² einmal durchstossen. Der Vorteil ist eine geringe Beschädigungsgefahr der Kontaktstellen beim Begehen des Daches und es ist kein Schützen der Kontaktstellen mit mechanischen Abdeckungen notwendig. Weiterhin ist nur eine Dichtungsbahnlage notwendig. Nachteilig ist das häufige Durchstossen der Dichtungsebene im Flachdachbereich. Durchstosslösungen sind in der Applikation besonders risikoreich bezüglich Undichtigkeiten und teuer, da sie besondere Anforderungen an die technische Lösung und das handwerkliche Geschick der Verarbeiter stellen. Verkabelungs- und Abdichtungsarbeiten müssen miteinander durchgeführt werden. Dies dauert länger und es sind mehr Personen auf dem Dach, was zu höheren Unsicherheiten bei der Verarbeitung führt. Das Risiko von Undichtigkeiten steigt damit zusätzlich.

Andererseits gibt es auch ein einlagiges System bei dem der Anschluss der Photovoltaikelemente an die Verkabelung oben auf dem Photovoltaikmodul, also der Oberseite, erfolgt und die Verkabelung auf dem Flachdach ebenfalls auf der Oberseite geschieht. Der Vorteil liegt darin, dass ein Durchstossen der Dichtungsebene vermieden wird, die Verkabelung nach Abschluss der Abdichtungsarbeiten möglich ist und nur eine Dichtungsbahnlage notwendig ist. Nachteilig ist die hohe Beschädigungsgefahr der Kontaktstellen beim Begehen des Daches oder aufwändiges Schützen der Kontaktstellen mit mechanischen Abdeckungen.

### Darstellung der Erfindung

Es ist daher Aufgabe der Erfindung, ein neues Photovoltaikelement zu finden, welches die Vorteile der einlagigen Systeme und zweilagigen Systeme weitestgehend erfüllt und deren Nachteile jedoch möglichst meidet.

Diese Aufgabe wird durch die Merkmale des unabhängigen Patentanspruches 1 gelöst. Vorteilhafte Weiterbildungen der Erfindung sind Gegenstand untergeordneter Ansprüche.

Kern der Erfindung ist es also, dass die Kontaktstellen des Photovoltaikmoduls auf der zur Dichtungsbahn gewandten Seite angeordnet sind und die Mittel zum elektrischen Anschluss die Dichtungsbahn durchstossen.

Eine vorteilhafte Ausbildung des Photovoltaikelementes sieht vor, dass die Mittel zum elektrischen Anschluss an die Kontaktstellen die Dichtungsbahn zweimal durchstossen. Im Fall von mehreren Fotovoltaikmodulen sieht eine vorteilhafte Ausbildung des Photovoltaikelementes vor, dass die Mittel zur elektrischen Verbindung der Kontaktstellen die Dichtungsbahn zwischen zwei Kontaktstellen zweimal durchstossen, vorzugsweise auch die Mittel zum elektrischen Anschluss nach der Kontaktstelle am Photovoltaikmodul die Dichtungsbahn zweimal durchstossen.

Für eine sehr sichere Abdichtung kann gesorgt werden, indem im Bereich der Durchstosspunkte der Dichtungsbahn auf der Unterseite der Dichtungsbahn eine zusätzliche Abdeckungsbahn entlang der Durchstosspunkte aufgebracht, insbesondere aufgeschweisst und/oder aufgeklebt, wird, wobei diese vorzugsweise aus Kunststoff, insbesondere aus dem gleichen Material wie die Dichtungsbahn selbst, bestehen sollte. Die zusätzliche Abdeckungsbahn sollte dabei in ihrer Längsrichtung entlang der Durchstosspunkte verlaufen.

Eine besonders sichere Variante bezüglich der Abdichtungssicherheit wird allerdings erreicht, wenn im Bereich der Abdeckungsbahn ein Formstück angeordnet ist, welches einen luftdurchgängigen Anschluss an einen durch Abdeckungsbahn und Dichtungsbahn gebildeten Hohlraum schafft. Hierdurch kann mit Hilfe eines Vakuumtests die Dichtheit des Systems nachgewiesen werden.

Günstig ist es dabei, wenn das Formstück mit der Dichtungsbahn oder noch besser auf der Unterseite der Dichtungsbahn verbunden, insbesondere verschweisst und/oder verklebt, ist. Wird ein solches Formstück verwendet, so kann dieses zusätzlich besonders vorteilhaft dazu verwendet werden auch mindestens einen elektrischer Anschluss oder alle elektrischen Anschlüsse durch dieses Formstück nach aussen zu führen. Hierdurch werden mögliche zusätzliche Leckagestellen vermieden.

Eine weitere vorteilhafte Ausbildung sieht vor, dass die Mittel zum elektrischen Anschluss Steckverbindungen aufweisen, damit ein einfaches Verkabeln möglich ist.

Weitere vorteilhafte Ausgestaltungen der Erfindung ergeben sich aus den Unteransprüchen.

### Kurze Beschreibung der Zeichnung

Im Folgenden wird die Erfindung anhand der Figuren näher beschrieben, wobei nur die zum Verständnis der Erfindung notwendigen Merkmale dargestellt sind. Es zeigen im Einzelnen:
- FIG 1:: Querschnitt durch ein Photovoltaikelement im Bereich der Kontaktstellen;
- FIG: 2: Querschnitt durch ein Photovoltaikelement mit Abdeckungsbahn im Bereich der Kontaktstellen;
- FIG 3:: Schrägansicht eines teilweise ausgerollten Photovoltaikelementes;
- FIG 4:: Entrolltes Photovoltaikelement mit vier Photovoltaikmodulen;
- FIG 5:: Querschnitt durch ein Photovoltaikelement im Bereich der Kontaktstellen;
- FIG: 6: Querschnitt durch ein Photovoltaikelement mit Abdeckungsbahn im Bereich der Kontaktstellen;
- FIG 7:: Querschnitt durch ein Photovoltaikelement mit Anschlusstülle für den Innenbereich zwischen Dichtungsbahn und Abdeckungsbahn;
- FIG 8:: Querschnitt durch ein Photovoltaikelement mit Anschlusstülle ähnlich Figur 7, jedoch mit Führung der Mittel zum elektrischen Anschluss durch Anschlusstülle für Dichtigkeitsprüfung.

### Wege zur Ausführung der Erfindung

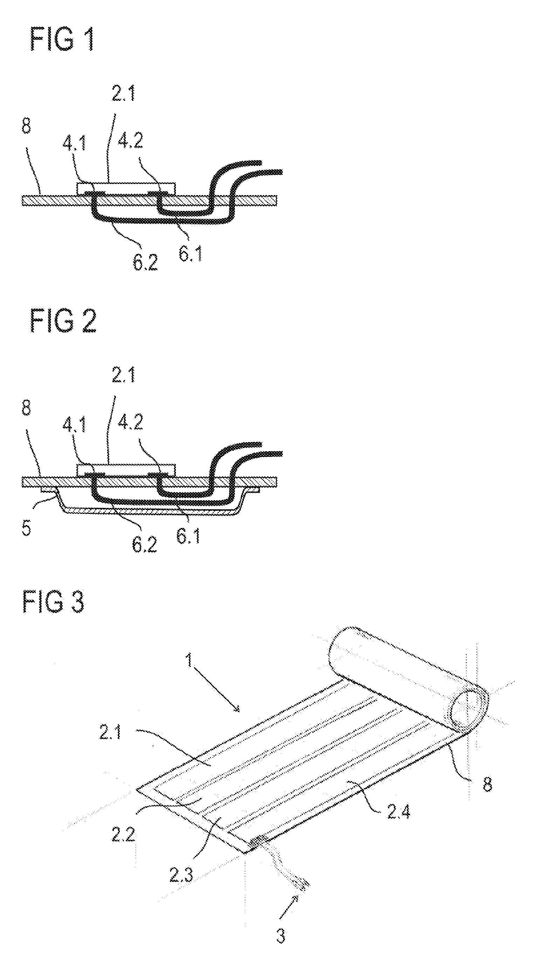

In der **Figur 1** ist ein erfindungsgemässes Fotovoltaikelement 1 mit einem, auf einer Seite der Dichtungsbahn befestigten Photovoltaikmodul 2.1 abgebildet. Die Kontaktstellen 4.1 und 4.2 des Photovoltaikmoduls 2.1 sind auf der zur Dichtungsbahn 8 gewandten Seite angeordnet und die Mittel zum elektrischen Anschluss 6.1 beziehungsweise 6.2 durchstossen die Dichtungsbahn 8. Die Kontaktstellen 4.1, 4.2 führen jeweils die positive beziehungsweise negative Polarität des jeweiligen Photovoltaikmoduls heraus. Die an den jeweiligen Kontaktstellen 4.1, 4.2 befestigten Mittel zum elektrischen Anschluss 6.1, beziehungsweise 6.2, können verwendet werden, um das Fotovoltaikelement 1 mit weiteren Fotovoltaikelementen seriell oder parallel zu verbinden. Natürlich können die an den Kontaktstellen 4.1, 4.2 befestigten Mittel zum elektrischen Anschluss 6.1, beziehungsweise 6.2, die Dichtungsbahn auch gemeinsam am selben Ort durchstossen. Im Falle eines Fotovoltaikelement 1 mit mehreren auf einer Seite der Dichtungsbahn befestigten Photovoltaikmodulen können die Photovoltaikmodule untereinander seriell oder parallel verbunden sein, wobei im Fall einer seriellen Verbindung unter anderem der Vorteil einer höheren Spannung, bei der parallelen Verbindung einer höheren Stromstärke resultiert.

In der **Figur 2** ist das Fotovoltaikelement 1 aus Figur 1 abgebildet, wobei zu erkennen ist, dass eine Abdeckungsbahn 5 auf der Unterseite der Dichtungsbahn 8 aufgebracht, insbesondere verklebt und/oder verschweisst, ist und dadurch auf sichere Weise die Gewähr für eine dauerhafte Abdichtung von Dächern mit Hilfe der Photovoltaikelemente 1 bietet.

Die **Figur 3** zeigt ein erfindungsgemässes Photovoltaikelement 1 in teilweise aufgerolltem Zustand, bestehend aus einer Dichtungsbahn 8, auf der vier Photovoltaikmodule 2.1 bis 2.4 fixiert sind und welches über eine gemeinsame Steckverbindung 3 für einen äusseren Stromanschluss verfügt.

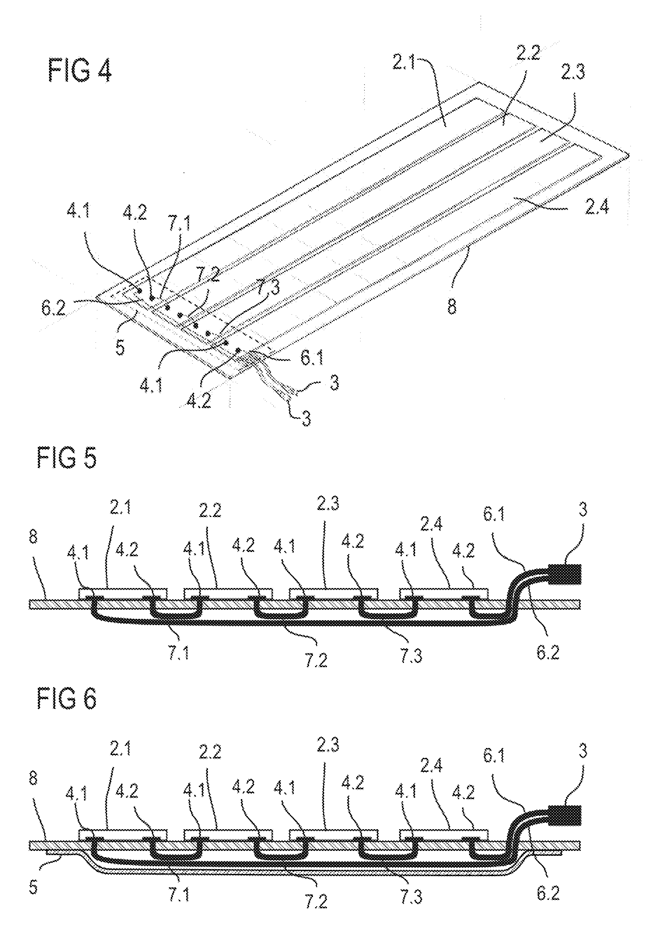

Die **Figur 4** zeigt ein solches Photovoltaikelement aus der Figur 3 in einem entrollten Zustand, wobei zur Darstellung der Erfindung im linken Bereich an den einzelnen Photovoltaikmodulen 2.1 bis 2.4 Kontaktstellen 4.1, 4.2 erkennbar sind, die jeweils die positive beziehungsweise negative Polarität des jeweiligen Photovoltaikmoduls herausführen und an denen Mittel zum elektrischen Anschluss an die Kontaktstellen 6.1, beziehungsweise 6.2, befestigt sind. Diese Kontaktstellen 4.1, 4.2 sind auf der Unterseite der Photovoltaikmodule 2.1 bis 2.4 angebracht, so dass sie in Richtung der darunter liegenden Dichtungsbahn 8 zeigen. An diesen Kontaktstellen 4.1 und 4.2 sind einerseits Mittel zur elektrischen Verbindung 7.1 bis 7.3 zwischen den einzelnen Photovoltaikmodulen 2.1 bis 2.4 kontaktiert, die unmittelbar nach ihrer jeweiligen Kontaktstellen die Dichtungsbahn 8 an Durchstosspunkten durchstossen, auf der Unterseite der Dichtungsbahn 8 verlaufen und wieder über einen Durchstosspunkt zur entgegengesetzt polarisierten Kontaktstelle des darüber liegenden Photovoltaikmoduls die Dichtungsbahn 8 nochmals durchstossen. Endständig in der seriellen Verbindungsreihe der Photovoltaikmodule 2.1 bis 2.4 ist jeweils ein Mittel zum elektrischen Anschluss 6.1 beziehungsweise 6.2 mit der Kontaktstelle verbunden, wobei diese unmittelbar hinter der Kontaktstelle die Dichtungsbahn 8 durchstossen und auf die Seite, auf der der gesamte elektrische Anschluss des Photovoltaikelementes 1 angeordnet ist, verlaufen, wo sie nochmals die Dichtungsbahn 8 von unten durchstossen. Natürlich ist es auch möglich, die Photovoltaikmodule 2.1 bis 2.4 untereinander parallel zu verbinden.

Im Bereich der Durchstosspunkte der dort verlaufenden Mittel zum elektrischen Anschluss 6.1, 6.2 und Mittel zur elektrischen Verbindung 7.1 bis 7.3 befindet sich auf der Unterseite der Dichtungsbahn nochmals eine Abdeckungsbahn 5, die diesen gesamten Bereich umschliesst und wasserdicht abdeckt. Die Abdeckungsbahn 5 ist mit der Dichtungsbahn 8 verbunden, insbesondere verklebt und/oder verschweisst, so dass eine sichere Dichtungssituation vorliegt.

In der **Figur 5** ist der Bereich der Durchstosspunkte beziehungsweise der Kontaktstellen 4.1 und 4.2 im Querschnitt nochmals dargestellt.

In der **Figur 6** ist das Fotovoltaikelement 1 aus Figur 5 abgebildet, wobei zu erkennen ist, dass die Abdeckungsbahn 5 auf der Unterseite der Dichtungsbahn 8 aufgebracht, insbesondere verklebt und/oder verschweisst, ist und dadurch auf sichere Weise die Gewähr für eine dauerhafte Abdichtung von Dächern mit Hilfe der Photovoltaikelemente 1 bietet.

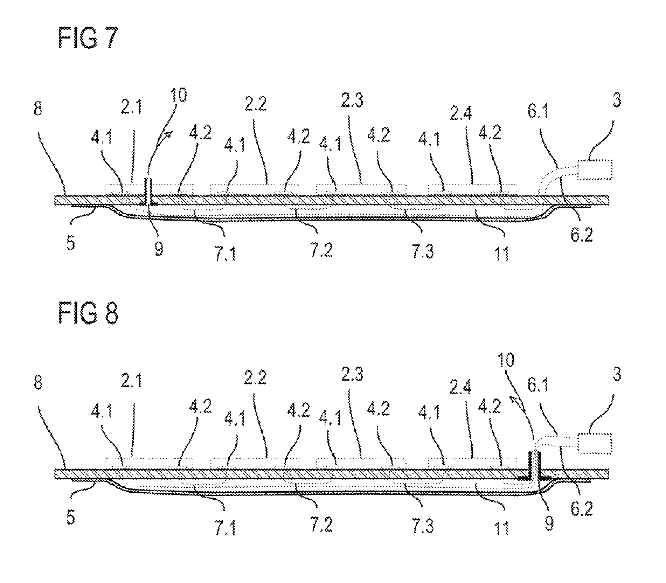

Eine weitere Verbesserung der Erfindung kann dadurch geschehen, dass - wie in der **Figur 7** gezeigt - zusätzlich eine Anschlusstülle 9 an der Dichtungsbahn 8 im Bereich des durch die Dichtungsbahn 8 und der darunter aufgebrachten, insbesondere verklebten und/oder verschweissten, Abdeckungsbahn 5 gebildeten Hohlraums angebracht ist. Durch diese Anschlusstülle, die beispielsweise flexibel und starr ausgebildet sein kann und als Formstück an die Dichtungsbahn 8 angeschweisst werden kann, kann durch Absaugen von Luft 10 ein Vakuum im Zwischenraum 11, zwischen der Dichtungsbahn 8 und der Abdeckungsbahn 5, erzeugt werden. Hierdurch lässt sich entsprechend einem gegebenenfalls messbaren Druckabfall die Dichtigkeit überprüfen, so dass die Dichtheit des gesamten Systems des Photovoltaikelementes 1 mit hoher Sicherheit gewährleistet ist. Ausserdem kann diese Anschlusstülle auch dazu verwendet werden, die Mittel zum elektrischen Anschluss 6.1, beziehungsweise 6.2, nach aussen zu führen, wie es in der **Figur 8** dargestellt ist. Durch diese Massnahme werden mögliche Leckagen aufgrund weiterer Durchbrüche vermieden. Zur Dichtigkeitsüberprüfung muss dann ein Luftanschluss verwendet werden, der es erlaubt, kurzfristig den Stecker 3 mit aufzunehmen, oder es müssen die Anschlüsse an den Stecker erst später erstellt werden, so dass ausschliesslich die Mittel zum elektrischen Anschluss 6.1 und 6.2 im Luftanschluss unterzubringen sind.

Es versteht sich, dass die vorstehend genannten Merkmale der Erfindung nicht nur in der jeweils angegebenen Kombination, sondern auch in anderen Kombinationen oder in Alleinstellung verwendbar sind, ohne den Rahmen der Erfindung zu verlassen.

### Bezugszeichenliste

- 1: Photovoltaikelement
- 2.1-2.4: Photovoltaikmodule
- 3: Steckverbindung
- 4.1, 4.2: Kontaktstellen
- 5: Abdeckungsbahn
- 6.1, 6.2: Mittel zum elektrischen Anschluss
- 7.1-7.3: Mittel zur elektrischen Verbindung
- 8: Dichtungsbahn
- 9: Formstück / Anschlusstülle
- 10: Luft
- 11: Zwischenraum

## Patentansprüche

1. Photovoltaikelement (1) aufweisend eine Dichtungsbahn (8) mit mindestens einem, auf einer Seite der Dichtungsbahn befestigten Photovoltaikmodul (2.1-2.4), welches Kontaktstellen (4.1, 4.2) und Mittel zum elektrischen Anschluss (6.1, 6.2) aufweist,
**dadurch gekennzeichnet,**
**dass** die Kontaktstellen (4.1, 4.2) des Photovoltaikmoduls (2.1-2.4) auf der zur Dichtungsbahn (8) gewandten Seite angeordnet sind, und die Mittel zum elektrischen Anschluss (6.1, 6.2) die Dichtungsbahn (8) durchstossen.

2. Photovoltaikelement (1) gemäss dem voranstehenden Patentanspruch 1,
**dadurch gekennzeichnet,**
**dass** die Mittel zum elektrischen Anschluss (6.1, 6.2) die Dichtungsbahn (8) zweimal durchstossen.

3. Photovoltaikelement (1) gemäss einem der voranstehenden Patentansprüche 1 bis 2,
**dadurch gekennzeichnet,**
**dass** mindestens zwei auf einer Seite der Dichtungsbahn befestigte Photovoltaikmodule (2.1-2.4),
sowie Mittel zur elektrischen Verbindung (7.1-7.3) vorhanden sind.

4. Photovoltaikelement (1) gemäss dem voranstehenden Patentanspruch 3,
**dadurch gekennzeichnet,**
**dass** die Mittel zur elektrischen Verbindung (7.1-7.3) die Kontaktstellen (4.1, 4.2) untereinander elektrisch seriell verbinden.

5. Photovoltaikelement (1) gemäss einem der voranstehenden Patentansprüche 1 bis 4,
**dadurch gekennzeichnet,**
**dass** die Dichtungsbahn (8) eine flexible, bevorzugt eine flüssigkeitsdichte aus Kunststoff hergestellte Dichtungsbahn (8) ist.

6. Photovoltaikelement (1) gemäss einem der voranstehenden Patentansprüche 1 bis 5,
**dadurch gekennzeichnet,**
**dass** im Bereich von Durchstosspunkten der Dichtungsbahn (8) auf der Unterseite der Dichtungsbahn (8) eine zusätzliche Abdeckungsbahn (5) entlang der Durchstosspunkte aufgebracht, insbesondere aufgeschweisst und/oder aufgeklebt, ist.

7. Photovoltaikelement (1) gemäss dem voranstehenden Patentanspruch 6,
**dadurch gekennzeichnet,**
**dass** die Abdeckungsbahn (5) aus Kunststoff hergestellt ist.

8. Photovoltaikelement (1) gemäss dem voranstehenden Patentanspruch 6,
**dadurch gekennzeichnet,**
**dass** die Abdeckungsbahn (5) aus dem gleichen Material besteht wie die Dichtungsbahn (8).

9. Photovoltaikelement (1) gemäss einem der voranstehenden Patentansprüche 6 bis 8,
**dadurch gekennzeichnet,**
**dass** die Abdeckungsbahn (5) in ihrer Längsrichtung entlang der Durchstosspunkte verläuft.

10. Photovoltaikelement (1) gemäss einem der voranstehenden Patentansprüche 6 bis 9,
**dadurch gekennzeichnet,**
**dass** im Bereich der Abdeckungsbahn (5) ein Formstück (9) angeordnet ist, welches einen luftdurchgängigen Anschluss an einen durch Abdeckungsbahn (5) und Dichtungsbahn (8) gebildeten Hohlraum (11) schafft.

11. Photovoltaikelement (1) gemäss dem voranstehenden Patentanspruch 10,
**dadurch gekennzeichnet,**
**dass** das Formstück (9) mit der Dichtungsbahn (8) verbunden, insbesondere verklebt und/oder verschweisst, ist.

12. Photovoltaikelement (1) gemäss dem voranstehenden Patentanspruch 10,
**dadurch gekennzeichnet,**
**dass** das Formstück (9) auf der Unterseite der Dichtungsbahn (8) verbunden, insbesondere verklebt und/oder verschweisst, ist.

13. Photovoltaikelement (1) gemäss einem der voranstehenden Patentansprüche 10 bis 12,
**dadurch gekennzeichnet,**
**dass** mindestens ein Mittel zum elektrischen Anschluss (6.1, 6.2) durch das Formstück (9) nach aussen geführt wird.

14. Photovoltaikelement (1) gemäss einem der voranstehenden Patentansprüche,
**dadurch gekennzeichnet,**
**dass** die Mittel zum elektrischen Anschluss (6.1, 6.2) Steckverbindungen (3) aufweisen.

15. Photovoltaikelement (1) gemäss einem der voranstehenden Patentansprüche,
**dadurch gekennzeichnet,**
**dass** das Photovoltaikmodul (2.1-2.4) mindestens zwei im Betrieb unterschiedliche Polarität führende Kontaktstellen (4.1, 4.2) aufweist.

16. Photovoltaikelement (1) gemäss einem der voranstehenden Patentansprüche,
**dadurch gekennzeichnet,**
**dass** das Photovoltaikmodul (2.1-2.4) ein flexibles Photovoltaikmodul ist.
